# EUROPÄISCHE PATENTSCHRIFT

(11) **EP 3 278 638 B1**
(45) Veröffentlichungstag und Bekanntmachung des Hinweises auf die Patenterteilung: **08.05.2019**
(21) Anmeldenummer: 16709441.6
(22) Anmeldetag: 11.03.2016
(51) Int. Cl.: H05K 1/02, H05K 5/00, H01R 13/658, H05K 9/00

(54) **ELEKTRONISCHES GERÄT**
ELECTRONIC DEVICE
APPAREIL ÉLECTRONIQUE

(30) Priorität: 30.03.2015 DE 102015205700
(43) Veröffentlichungstag der Anmeldung: 07.02.2018
(73) Patentinhaber: Robert Bosch GmbH, 70442 Stuttgart (DE)
(72) Erfinder: KUHN, Jochen, 72574 Bad Urach (DE)
(86) Internationale Anmeldenummer: PCT/EP2016/055241
(87) Internationale Veröffentlichungsnummer: WO 2016/156011

(56) Entgegenhaltungen:
- DE-A1-102004 049 053
- DE-A1-102010 040 558
- JP-A- 2007 214 061
- US-A- 5 671 123
- US-A1- 2009 251 843

## Beschreibung

Die Erfindung betrifft ein elektronisches Gerät gemäß den Oberbegriffen der unabhängigen Ansprüche.

### Stand der Technik

Elektronische Geräte umfassen elektrische und/oder elektronische Schaltungen, welche sehr empfindlich sind gegenüber einer elektrostatischen Entladung. Zur elektrostatischen Entladung kann es aus verschieden Gründen kommen. Beispielsweise ist es möglich, dass Gehäuseteile - beispielsweise aus Kunststoff - sich elektrostatisch aufladen. Ab einer bestimmten Ladungsmenge kann es dann zu einem Überspringen der elektrostatischen Ladung vom Gehäuse auf elektrisch leitfähige Bereiche der elektrischen und/oder elektronischen Schaltung kommen. Ebenso ist es möglich, dass das elektronische Gerät in die Nähe oder in Kontakt zu einem ladungstragenden Element gelangt. Es ist grundsätzlich ausreichend, dass ein Potenzialunterschied zwischen dem elektronischen Gerät und dem weiteren Element vorliegt. Hierbei kann es zu einem Ladungsübertrag auf das Gehäuse des elektronischen Gerätes kommen, wobei die Entladung bei ausreichender Ladungsmenge wiederum bis zur elektrischen und/oder elektronischen Schaltung gelangen kann. Oft genug können elektrostatische Entladungen elektrische und/oder Bauelemente der elektrischen und/oder elektronischen Schaltung beschädigen. Zumindest kann es jedoch zum Zeitpunkt der elektrostatischen Entladung zu Betriebsstörungen des elektronischen Gerätes kommen.

Die Verträglichkeit gegenüber einer elektrostatischen Entladung kann bei elektronischen Geräten durch spezielle Testverfahren überprüft werden. In derartigen Testverfahren werden elektronische Geräte, beispielsweise Steuergeräte, in unmittelbarer Nähe zu ihrer Gehäusewandung einer durch eine Vorrichtung erzeugten Luftentladung ausgesetzt. In der Offenlegungsschrift DE 102010040558 A1 werden beispielsweise derartige Testverfahren beschrieben. Ebenso ist aus der genannten Offenlegungsschrift ein Steuergerät mit einem auf einer Leiterplatte angeordnetem Hoch-Impedanz Schaltungsteil bekannt. Zum Schutz des Hoch-Impedanz Schaltungsteiles ist auf der Leiterplatte ein zusätzliches Schutzelement vorgesehen, welches mit der Masse verbunden ist. Hierbei wird der Verlauf eines durch eine elektrostatische Entladung außerhalb des Steuergeräts hervorgerufenen elektrischen Feldes zum Schutzelement hin abgelenkt. Für das zusätzliche Schutzelement muss Bauraum auf der Leiterplatte vorgehalten werden.

Ebenso ist es bekannt, bei einem Steuergerät ein zusätzliches Schutzelement in Form einer Feder auszubilden. Eine derartige Feder kann dann mit einem Ende eine elektrische und/oder elektronische Schaltung auf einer Leiterplatte kontaktieren, insbesondere eine Masseleitung. Mit dem anderen Ende kontaktiert die Feder dagegen ein Gehäuseteil des Steuergerätes, beispielsweise einen metallischen Deckel. Durch den direkten Kontakt ist eine elektrostatische Entladung stets über die Feder sichergestellt. Eine derartige Feder beansprucht allerdings einen großen Bereich auf dem Leiterplattenlayout. Weiterhin muss der metallische Deckel während der Montage auf das Steuergerät mechanisch fixiert werden, da die Feder durch ihre Rückstellkraft den Deckel hochdrückt. Wird der Deckel beispielsweise verklebt, muss die mechanische Fixierung des Deckels bis zur vollständigen Aushärtung des Klebers erfolgen.

Aus der Offenlegungsschrift DE 102004049053 A1 ist ein Leitungsträger bekannt, welcher zumindest eine Funkenstrecke zum Überspannungsschutz zwischen zwei elektrischen leitfähigen Gebieten auf dem Leitungsträger aufweist. Derartige Funkenstrecken können in herkömmlichen Ätzverfahren auf der Leiterplatte strukturiert werden und eignen sich auch für die Ausbildung eines elektrostatischen Schutzes für Anschlusspins.

### Offenbarung der Erfindung

### Vorteile

Der Erfindung liegt die Aufgabe zu Grunde, einen einfachen und kostengünstigen elektrostatischen Schutz für ein elektronisches Gerät bereitzustellen.

Diese Aufgabe wird durch ein elektronisches Gerät mit den kennzeichnenden Merkmalen der unabhängigen Ansprüche gelöst.

Die Erfindung geht aus von einem elektronischen Gerät, insbesondere ein Steuergerät, mit einem Gehäuse, welches einen Hohlraum aufweist und in welchem ein mit elektrischen und/oder elektronischen Bauelementen bestückter Schaltungsträger unter Ausbildung einer elektrischen und/oder elektronischen Schaltung angeordnet ist. Ferner umfasst das elektronische Gerät ein mit dem Schaltungsträger kontaktiertes Sicherungselement zum Schutz der elektrischen und/oder elektronischen Schaltung vor elektrostatischer Entladung. Zusätzlich umfasst die elektrische und/oder elektronische Schaltung einen Steckerkontakt, welcher Anschlusspins aufweist. Dabei sind die Anschlusspins mit dem Schaltungsträger kontaktiert. Zumindest ein Anschlusspin ist als das Sicherungselement ausgebildet, indem der zumindest eine Anschlusspin mit einer Masseleitung verbunden ist und ein kleinster Abstand des Gehäuses zu einem elektrisch leitfähigen Bereich der elektrischen und/oder elektronischen Schaltung an einer Stelle des zumindest einen als das Sicherungselement ausgebildeten Anschlusspin gegeben ist, wodurch bei einer elektrostatischen Entladung ein präferierter Entladepfad zwischen dem Gehäuse und der Masseleitung gebildet ist. In vorteilhafter Weise übernimmt ein in der elektrischen und/oder elektronischen Schaltung bereits enthaltendes Bauelement, nämlich der Steckerkontakt, neben der Bereitstellung einer elektrischen und/oder mechanischen Kontaktierungsmöglichkeit der elektrischen und/oder elektronischen Schaltung, beispielsweise mit einer Stromversorgungs- und/oder Ansteuerleitung, zusätzlich die Funktion eines elektrostatischen Schutzes. Dadurch ergibt sich der große Vorteil, dass durch Vorsehen eines elektrostatischen Schutzes erfindungsgemäß weder zusätzliche Kosten entstehen, noch weiterer Bauraum auf dem Schaltungsträger vorgehalten werden muss. Dadurch kann die elektrische und/oder elektronische Schaltung vor elektrostatischer Entladung wirkungsvoll geschützt werden und gleichzeitig sehr kompakt ausgeführt bleiben. Als der zumindest eine als das Sicherungselement ausgebildete Anschlusspin ist jener auszuwählen, welcher für die Schaltungsfunktion nicht gebraucht wird und daher beispielsweise einen ansonsten nicht belegten Anschlusspin des Steckerkontaktes darstellen würde. Die Masseleitung kann in einer einfachen Ausführungsform auf dem Schaltungsträger, beispielsweise als Bestandteil der elektrischen und/oder elektronischen Schaltung, vorliegen. Ebenso besteht in einer anderen Ausführungsform die Möglichkeit, dass die Masseleitung durch einen mit dem Steckerkontakt zusammenwirkenden Gegenstecker bereitgestellt ist, wobei der Gegenstecker die Masseleitung beim Einstecken in den Steckerkontakt mit dem als das Sicherungselement ausgebildeten Anschlusspin kontaktiert. Grundsätzlich kann der Gegenstecker weitere Leitungen umfassen, beispielsweise Stromversorgungs-, Prüf- oder Signalansteuerleitungen, welche dann die anderen Anschlusspins des Steckerkontaktes kontaktieren. Demnach sind die anderen Anschlusspins des Steckkontakts für den Betrieb und die Funktion der elektrischen und/oder elektronischen Schaltung in Abhängigkeit des Anwendungsfalles des elektronischen Gerätes definiert belegt.

In einer vorteilhaften Ausführungsform ist der Entladepfad über eine den kleinsten Abstand überbrückende Funkenstrecke geführt. Demnach weist der Entladepfad einen kontaktfreien Abschnittsbereich auf, welcher einen zwischen dem Gehäuse und dem zumindest einen als das Sicherungselement ausgebildeten Anschlusspin vorliegenden Luftspalt umfasst. Dieser Luftspalt kann bei einer elektrostatischen Entladung durch eine Luftentladung überwunden werden, wobei zum Zeitpunkt der elektrostatischen Entladung eine Funkenstrecke den vorliegenden Luftspalt vollständig überbrückt. Durch den fehlenden mechanischen Kontakt ist die Übertragung mechanischer Belastungen vom Gehäuse auf das in beschriebener Weise vorgesehene Sicherungselement, den Steckerkontakt insgesamt und/oder den Schaltungsträger auszuschließen. Durch eine Toleranzrechnung kann ein Mindestabstand zugrunde gelegt werden, welcher auch bei ungünstigster sich ergebender Toleranzkette aller die den kleinsten Abstand einstellenden Maßangaben einen noch verbleibenden Lustspalt für die Funkenstrecke sicherstellt. In gleicher Weise wird der maximal zulässige Luftspalt zur Ausbildung einer Funkenstrecke bei einer vorgegeben elektrostatischen Entladungsmöglichkeit geprüft.

In einer alternativen Ausführungsform kontaktiert der zumindest eine als das Sicherungselement ausgebildeter Anschlusspin das Gehäuse. Zur Vermeidung von Beschädigungen oder zu großen mechanischen Belastungen erfolgt eine solche Kontaktierung federnd. Dies kann beispielsweise dadurch erreicht werden, dass sich an die Kontaktstelle des zumindest einen als das Sicherungselement ausgebildeten Anschlusspins zumindest ein Abschnittsbereich anschließt, welcher nachgiebig gestaltet ist. Bei drahtförmig ausgeführten Anschlusspins ist eine derartige Realisierung sehr einfach. Bei einem ausreichend langen Drahtabschnitt ist diesem ermöglicht, bei einer Krafteinwirkung quer zu einer Drahterstreckung sich in Richtung der Kraftwirkung elastisch zu verformen. So kann der Drahtabschnitt ein Ende des Anschlusspins sein oder zwischen zwei befestigten Enden des Anschlusspins angeordnet sein. Indem der Drahtabschnitt und das Gehäuse relativ zueinander in einem Winkel angeordnet sind, erfolgt im Augenblick der Ausbildung einer Kontaktstelle, beispielsweise bei der Montage des elektronischen Gerätes, ein Wegdrücken des elastisch nachgiebigen Drahtabschnittes durch das Gehäuse bis zu einer Kontaktstellung, welche für den Betrieb des elektronischen Gerätes vorgegeben ist.

Eine besondere Ausführungsform sieht vor, dass das Gehäuse eine in den Hohlraum abstehende Ausformung aufweist und der kleinste Abstand dann zu der Ausformung gebildet ist. Auf diese Weise ist es nicht erforderlich, dass der als das Sicherungselement vorgesehene Anschlusspin als das am weitesten abstehende Element der elektrischen und/oder elektronischen Schaltung ausgebildet sein muss. Vielmehr ergibt sich durch diese Ausführungsform der Vorteil, dass eine beliebige Topologie bzw. ein vielseitiger Aufbau der elektrischen und/oder elektronischen Schaltung vorliegen kann. Durch Vorsehen der zuvor genannten Ausformung wird demnach gezielt ein Entgegenkommen des Gehäuses im Bereich des zumindest einen als das Sicherungselement ausgebildeten Anschlusspins vorgesehen, derart, dass genau in diesem Bereich dann der kleinste Abstand des Gehäuses zu einem leitfähigen Bereich der elektrischen und/oder elektronischen Schaltung sichergestellt ist. In vorteilhafter Weise ist somit eine Berücksichtigung des vorgesehenen Sicherungselementes an einer beliebigen Position auf dem Schaltungsträger ermöglicht.

Eine mögliche Ausführungsform sieht ferner vor, dass das Gehäuse zumindest zwei den Hohlraum ausbildende Gehäuseelemente umfasst. So ist beispielsweise als das eine Gehäuseelement ein Deckel und als das weitere Gehäuseelement ein durch den Deckel verschließbares Bodenelement denkbar. Ferner ist zumindest eines der Gehäuseelemente, beispielsweise der Deckel, als ein Gussteil ausgebildet. In diesem Fall lässt sich die zuvor beschriebene als in den Hohlraum des Gehäuses abstehende Ausformung in einfacher Weise als ein im Gussteil entsprechend angeformter Domaufsatz realisieren. Der Domaufsatz kann dabei Bearbeitungsflächen aufweisen, beispielsweise durch einen mechanischen Abtrag, wie beispielsweise durch einen Fräsvorgang. Somit kann der kleinste Abstand zwischen dem Domaufsatz und dem zumindest einen als das Sicherungselement ausgebildeten Anschlusspin in einem engen Toleranzbereich realisiert werden. Gleiches gilt für den Fall einer alternativen Ausführungsform, bei welcher eines der Gehäuseelemente als ein Blechteil, insbesondere in Form eines Stanz- und Tiefziehteiles, ausgebildet ist. Hierbei kann in besonders einfacher Weise eine Vertiefung in Ausbildung der zuvor genannten Ausformung durch ein Tiefziehwerkzeug ausgeführt werden. Ferner kann die Position bei Bedarf auch angepasst auf das jeweilige Leiterplattenlayout durch einen Einsatz im Tiefziehwerkzeug verändert werden. Auf diese Weise kann die Fertigung unterschiedlicher elektronischer Geräte flexibel gehalten werden. Grundsätzlich kann eines der Gehäuseelemente aus einem Metall gebildet sein, wobei das andere Gehäuseelement aus einem Kunststoff, insbesondere als ein Kunststoffspritzgussteil, ausgeführt ist.

In einer sehr vorteilhaften Ausführungsform ist der in der elektrischen und/oder elektronischen Schaltung enthaltene Steckerkontakt derart zu dem Schaltungsträger angeordnet, dass seine Anschlusspins jeweils mit ihrem einen Ende von einer Seite des Schaltungsträgers durchgesteckt sind und von der anderen Seite des Schaltungsträgers dann abstehen. Die eine Seite des Schaltungsträgers kann dabei beispielsweise einer Gehäuseseite zugewandt sein, so dass auch die Anschlusspins zu dieser Gehäuseseite weisen, insbesondere senkrecht auf diese weisen. Die Stelle des kleinsten Abstandes ist dann durch das abstehende Ende des zumindest einen als Sicherungselement ausgebildeten Anschlusspins sehr einfach gegeben, indem beispielsweise die Gehäuseseite zusätzlich die in Richtung des Sicherungselementes abstehende Ausformung aufweist. Alternativ ist das abstehende Ende des zumindest einen als das Sicherungselement ausgebildeten Anschlusspins länger ausgebildet, als die jeweils abstehenden Enden der restlichen Anschlusspins. Auf diese Weise ergibt sich der kleinste Abstand in einfachster Weise an der Stelle des vorgesehenen Sicherungselementes.

In einer bevorzugten Ausführungsform ist der Hohlraum im Gehäuse durch Gehäuseseiten umgrenzt und der kleinste Abstand zu einem Randbereich einer der Gehäuseseiten gegeben. Bevorzugt ist dabei der Hohlraum im Wesentlichen quaderförmig ausgebildet. Insbesondere sind die Gehäuseseiten durch weitestgehen sich lateral erstreckende Gehäusewandungen gebildet, welche im Wesentlichen rechtwinklig zueinander stehen. Die Randbereiche dieser Gehäuseseiten stellen dabei die Bereiche der größten Gehäusesteifigkeit dar. Jegliche mechanische Belastungen des Gehäuses führen demnach in diesen Randbereichen nur zu kleinen oder idealer Weise vernachlässigbar kleinen Verformungen. Somit kann der einmal vorgegeben kleinste Abstand zwischen dem als das Sicherungselement ausgebildeten Anschlusspin auch im Betrieb des elektronischen Gerätes gehalten werden. Im Übrigen ergibt sich eine derartige Ausführungsform sehr einfach, indem der Steckerkontakt in einem Randbereich des Schaltungsträgers angeordnet ist, wobei der Schaltungsträger in einem geringen Abstand vom Gehäuse umschlossen ist. Hierbei lässt sich eine einfache Ausführungsform derart erhalten, bei welcher das elektronische Gerät einen aus dem Gehäuse herausführenden Steckerkontakt umfasst. Dabei weist das Gehäuse beispielsweise einen Durchbruch auf, durch welchen der Steckerkontakt geführt ist. Zusätzlich kann der Steckerkontakt dann zusätzlich am Gehäuse befestigt sein und beispielsweise gegenüber dem Durchbruch abgedichtet sein. Auf diese Weise lässt sich die im Gehäuse angeordnete elektrische und/oder elektronische Schaltung außerhalb des Gehäuses kontaktieren, insbesondere mit einer Stromversorgungs- und/oder Signalansteuerleitung.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnung. Diese zeigt in:
Fig. 1: ein elektronisches Gerät in einer seitlichen Schnittdarstellung,
Fig. 2a: Detailansicht einer ersten Ausführungsform zur Einstellung eines kleinsten Abstandes zwischen dem Gehäuse und dem zumindest einen als das Sicherungselement ausgeführten Anschlusspin eines Steckerkontaktes,
Fig. 2b: Detailansicht einer zweiten Ausführungsform zur Einstellung eines kleinsten Abstandes zwischen dem Gehäuse und dem zumindest einen als das Sicherungselement ausgeführten Anschlusspin eines Steckerkontaktes.

### Ausführungsformen der Erfindung

In den Figuren sind funktional gleiche Bauteile jeweils mit gleichen Bezugszeichen gekennzeichnet.

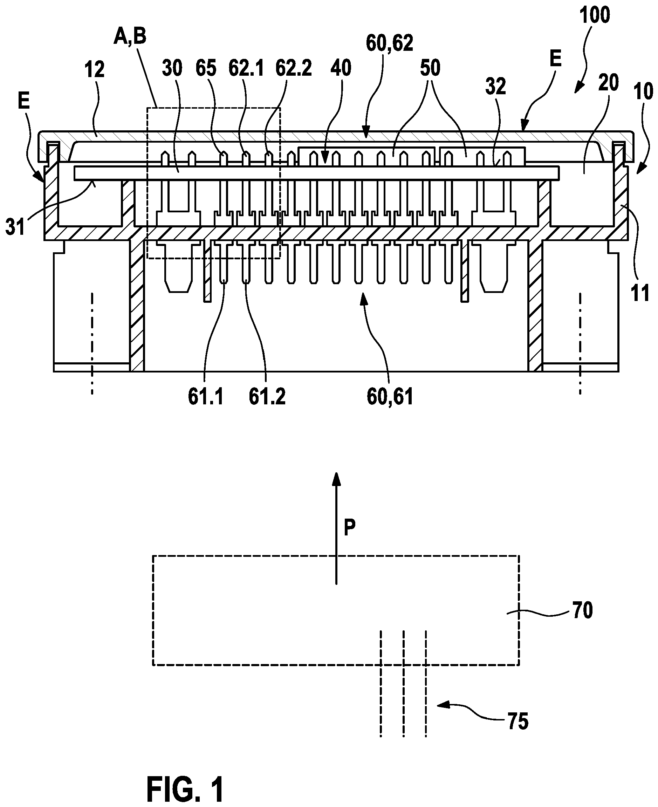

Fig. 1 zeigt ein erfindungsgemäße elektronisches Gerät 100 in einer seitlichen Schnittdarstellung. Das elektronische Gerät 100 umfasst ein Gehäuse 10, welches aus einem Bodenelement 11 und einem Deckel 12 besteht. Das Bodenelement 11 ist beispielsweise aus Kunststoff gebildet, insbesondere als ein Kunststoffspritzgussteil. Der Deckel 12 ist beispielsweise aus Metall gebildet, insbesondere aus Al oder einer Al-Legierung. Der Deckel 12 ist dabei auf dem Bodenelement 11 aufgesetzt und mit diesem befestigt, beispielsweise durch Verschrauben oder Verkleben. Dabei ist zwischen dem Deckel 12 und dem Bodenteil 11 ein Hohlraum 20 des Gehäuses 10 ausgebildet. Innerhalb des Hohlraumes 20 ist ein Schaltungsträger 30 aufgenommen. Auf einer Oberseite 32 und/oder einer Unterseite 31 des Schaltungsträgers 30 ist eine Leiterbahnstruktur ausgebildet (nicht dargestellt). Ferner ist der Schaltungsträger 30 mit zumindest einem elektrischen und/oder elektronischen Bauelement 50 bestückt. Das elektrische und/oder elektronische Bauelement 50 ist wiederum mit der Leiterbahnstruktur verbunden, wobei insgesamt auf dem Schaltungsträger 30 eine elektrische und/oder elektronische Schaltung 40 ausgebildet ist. Die elektrische und/oder elektronische Schaltung 40 umfasst hierbei auch einen Steckerkontakt 60. Der Steckerkontakt 60 ist dabei durch eine Wandung des Bodenelementes 11 durchgeführt. Im Falle eines Kunststoffspritzgussteiles des Bodenelementes 11 kann der Steckerkontakt 60 beispielsweise im Kunststoff mit eingespritzt sein. Insgesamt weist der Steckerkontakt 60 Anschlusspins 61 auf, welche aus dem Gehäuse 10 herausgeführt sind. Der Steckerkontakt 60 umfasst dabei gleich mehrere derartige Anschlusspins 61, beispielsweise einen ersten und einen zweiten außenliegenden Anschlusspin 61.1, 61.2. Ferner sind diese auch in den Hohlraum 20 des Gehäuses geführt, wobei sie dort als innenliegende Anschlusspins 62, beispielsweise als ein erster und ein zweiter innenliegender Anschlusspin 62.1, 62.2, vorliegen. Diese sind mit ihrem jeweiligen Ende dabei von der Unterseite 31 her durch den Schaltungsträger 30 durchgesteckt, so dass sie dann von der Oberseite 32 überstehen. Die meisten der innenliegenden Anschlusspins 62 sind dabei mit der Leiterbahnstruktur des Schaltungsträgers 30 verbunden, so dass über diese eine Stromversorgung und/oder auch eine Signalansteuerung der elektrischen und/oder elektronischen Schaltung 40 erfolgen kann. Hierfür kann beispielsweise ein Gegenstecker 70 von außen in einer Steckrichtung P auf den Steckerkontakt 60 aufgebracht werden. Der Gegenstecker 70 ist mit verschiedenen Leitungen 75 kontaktiert, beispielsweise einer Stromversorgungs-, Signalansteuer-, eine Masse- und/oder einer Prüfleitung. Der Steckerkontakt 50 weist ferner einen innenliegenden Anschlusspin 65 auf, welcher für die Stromversorgung, die Prüfung oder die Signalansteuerung der elektrischen und/oder elektronischen Schaltung 40 nicht gebraucht wird und daher in üblichen elektronischen Geräten unbelegt bleiben. Dieser Anschlusspin 65 wird nun im erfindungsgemäßen elektronischen Gerät 100 als ein Sicherungselement zum Schutz der elektrischen und/oder elektronischen Schaltung 40 vor elektrostatischen Entladungen E ausgebildet. Hierzu ist der als Sicherungselement ausgebildete Anschlusspin 65 mit einer Masseleitung verbunden. Diese kann beispielsweise auf dem Schaltungsträger 30 ausgebildet sein und durch den genannten Anschlusspin 65 kontaktiert sein. Ebenso kann die Masseleitung als eine der Leitungen 75 des Gegensteckers 70 durch entsprechende Kontaktierung des Steckerkontaktes 60 bereitgestellt sein.

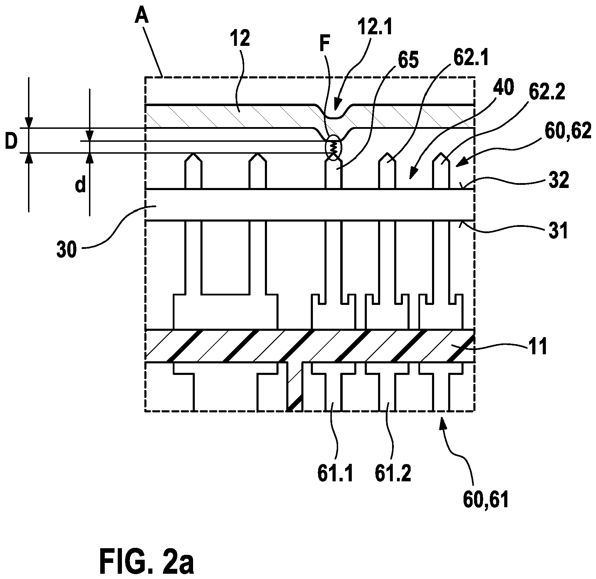

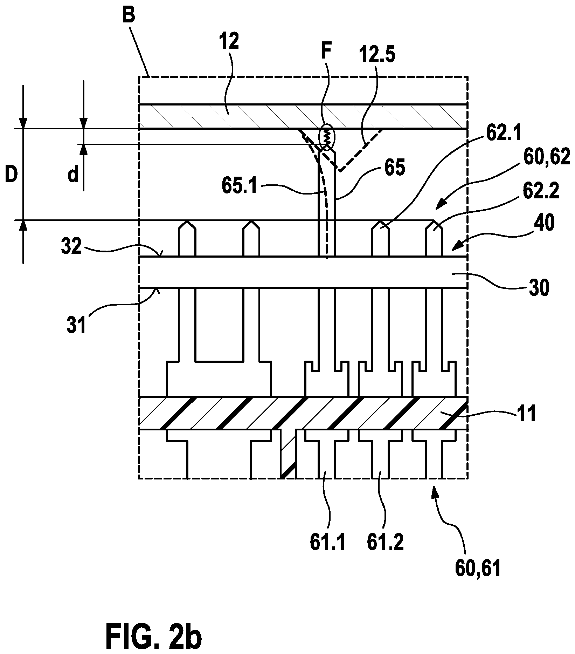

Mit A und B ist in Fig. 1 ein Ausschnitt des erfindungsgemäßen Gerätes 100 gekennzeichnet, welcher in den Fig. 2a und 2b in einer jeweils dargestellten Detailansicht in unterschiedlicher Ausführungsform gezeigt ist. Grundsätzlich zeigen die Fig. 2a und 2b eine Beabstandung D, d des Gehäuses 10 zu leitfähigen Bereichen der elektrischen und/oder elektronischen Schaltung 40. Dabei ist an einer Stelle des als Sicherungselement ausgebildeten Anschlusspins 65 ein kleinster Abstand d ausgebildet. Im Vergleich hierzu weisen die anderen innenliegenden Anschlusspins 62, beispielsweise 62.1 und 62.2, sowie die Leiterbahnstruktur und auch das zumindest eine elektrische und/elektronische Bauelement 50 einen größeren Abstand D zum Gehäuse auf. Ferner ist zwischen dem als Sicherungselement ausgebildeten Anschlusspin 65 und dem Deckel 12 ein verbleibender Luftspalt, so dass beide aneinander nicht berühren. In der Ausführungsform gemäß der Fig. 2a ergibt sich der kleinste Abstand d dadurch, dass im Bereich des als Sicherungselement ausgebildeten Anschlusspins 65 eine Ausformung 12.1 im Deckel 12 ausgebildet ist, welche dem Sicherungselement entgegenkommt. Die Ausformung 12.1 ist beispielsweise durch eine Vertiefung in einem als Tiefziehteil ausgebildetem Deckel 12 ausgeführt. In ähnlicher Weise ergibt sich ein kleinster Abstand d dadurch, dass bei einem Deckel 12 als Gussteil, die Ausformung 12.1 als ein angesetzter Domaufsatz vorgesehen ist. In der Ausführungsform gemäß der Fig. 2b ist dagegen der kleinste Abstand d dadurch eingestellt, dass der als das Sicherungselement ausgebildete Anschlusspin 65 länger ausgeführt ist, als die restlichen innenliegenden Anschlusspins 62 und somit dem Deckel 12 entsprechend am nächsten kommt. In dieser Ausführungsform kann dann der Deckel 12 insgesamt oder zumindest in dem Bereich oberhalb des Steckerkontaktes 60 eben ausgeführt bleiben.
Zum Zeitpunkt einer Entladung E kommt es bei den beschriebenen Ausführungsformen gemäß der Fig. 2a und 2b zu einer Luftentladung an der Stelle des kleinsten Abstandes d, wodurch der dort vorliegende Spalt durch eine sich ausbildende Funkenstrecke F überbrückt wird. Damit kann die Entladung über die mit dem als Sicherungselement ausgebildeten Anschlusspin 65 verbundene Masseleitung abgeleitet werden und die elektrische und/oder elektronische Schaltung 40 vor Beschädigung oder Störung wirkungsvoll geschützt werden.

In Fig. 2b ist noch eine alternative Ausführungsform derart gezeigt, dass im montierten Zustand des Deckels 12 auf dem Bodenelement 11 eine Kontaktstelle zwischen dem Deckel 12 und dem als das Sicherungselement ausgebildeten Anschlusspin 65 vorliegt. Hierbei ist im Deckel 12 beispielsweise ein schräg ausgeformter Ansatz 12.5 vorgesehen, welcher in Montageendstellung des Deckels 12 den Anschlusspin 65 seitlich wegdrückt und diesen elastisch verformt. Dabei liegt der als das Sicherungselement 65 ausgebildete Anschlusspin 12 an der Schräge des Ansatzes 12.5 an und weist einen entsprechenden Biegeverlauf 65.1 auf. Bei ausgebildeten innenliegenden Anschlusspins 62, welche zwischen dem Schaltungsträger 30 und den außenliegenden Anschlusspins 61 abgewinckelt ausgeführt sind, können beispielsweise auch in diesem angewinkelten Bereich durch einen vergleichbaren Ansatz 12.5 ein als das Sicherungselement ausgebildeter Anschlusspin 65 unter Ausbildung eines Berührungskontaktes elastisch verformt sein.

Somit ist der kleinste Abstand durch einen Berührungskontakt gegeben. In diesem Fall erfolgt ein Entladepfad der elektrostatischen Entladung dann direkt über den Berührungskontakt, ohne dass eine Funkenstrecke auszubilden ist.

## Patentansprüche

1. Elektronisches Gerät (100), insbesondere ein Steuergerät, mit einem Gehäuse (10), welches einen Hohlraum (20) aufweist und in welchem ein mit elektrischen und/oder elektronischen Bauelementen (50) bestückter Schaltungsträger (30) unter Ausbildung einer elektrischen und/oder elektronischen Schaltung (40) angeordnet ist, und mit einem mit dem Schaltungsträger (30) kontaktierten Sicherungselement (65) zum Schutz der elektrischen und/oder elektronischen Schaltung (40) vor elektrostatischen Entladungen (E),
**dadurch gekennzeichnet, dass**
die elektrische und/oder elektronische Schaltung (40) einen Steckerkontakt (60) umfasst, welcher Anschlusspins (61, 62) aufweist und die Anschlusspins (62) mit dem Schaltungsträger (30) kontaktiert sind, wobei zumindest ein Anschlusspin (65) als das Sicherungselement ausgebildet ist, indem der zumindest eine Anschlusspin (65) mit einer Masseleitung verbunden ist und ein kleinster Abstand (d) des Gehäuses (10) zu einem elektrisch leitfähigen Bereich der elektrischen und/oder elektronischen Schaltung (40) an einer Stelle des zumindest einen als das Sicherungselement ausgebildeten Anschlusspin (65) gegeben ist, wodurch bei einer elektrostatischen Entladung (E) ein präferierter Entladepfad zwischen dem Gehäuse (10) und der Masseleitung gebildet ist.

2. Elektronisches Gerät (100) nach Anspruch 1,
**dadurch gekennzeichnet, dass**
der Entladepfad über eine den kleinsten Abstand (d) überbrückende Funkenstrecke (F) geführt ist.

3. Elektronisches Gerät (100) nach Anspruch 1,
**dadurch gekennzeichnet, dass**
der zumindest eine als das Sicherungselement ausgebildeter Anschlusspin (65) das Gehäuse (10), insbesondere federnd, kontaktiert.

4. Elektronisches Gerät (100) nach einem der vorhergehenden Ansprüche,
**dadurch gekennzeichnet, dass**
das Gehäuse (10) eine in den Hohlraum (20) abstehende Ausformung (12.1, 12.5) aufweist und der kleinste Abstand (d) zu der Ausformung (12.1, 12.5) gebildet ist.

5. Elektronisches Gerät (100) nach Anspruch 4,
**dadurch gekennzeichnet, dass**
das Gehäuse (10) zumindest zwei den Hohlraum (20) ausbildende Gehäuseelemente (11, 12) umfasst, wobei zumindest eines der Gehäuseelemente (11, 12) als ein Gussteil oder als ein Blechteil ausgebildet ist, wobei die Ausformung (12.1, 12.5) im Gehäuse (10) als ein Domaufsatz in dem Gussteil oder als eine Vertiefung in dem Blechteil vorgesehen ist.

6. Elektronisches Gerät (100) nach einem der vorhergehenden Ansprüche,
**dadurch gekennzeichnet, dass**
die Anschlusspins (62) jeweils mit ihrem einen Ende von einer Seite (31) des Schaltungsträgers (30) durchgesteckt sind und von der anderen Seite (32) des Schaltungsträgers (30) abstehen, wobei die Stelle des kleinsten Abstandes (d) durch das abstehende Ende des zumindest einen als Sicherungselement ausgebildeten Anschlusspins (65) gegeben ist.

7. Elektronisches Gerät (100) nach Anspruch 6,
**dadurch gekennzeichnet, dass**
das abstehende Ende des zumindest einen als das Sicherungselement ausgebildeten Anschlusspins (65) länger ausgebildet ist als die abstehenden Ende der restlichen Abschlusspins (62).

8. Elektronisches Gerät (100) nach einem der vorhergehenden Ansprüche,
**dadurch gekennzeichnet, dass**
der Hohlraum (20) im Gehäuse (10) durch Gehäuseseiten umgrenzt ist und der kleinste Abstand (d) zu einem Randbereich einer der Gehäuseseiten gegeben ist.

9. Elektronisches Gerät (100) nach einem der vorhergehenden Ansprüche,
**dadurch gekennzeichnet, dass**
das elektronische Gerät (100) einen aus dem Gehäuse (10) herausführenden Steckerkontakt (60) umfasst.

## Claims

1. Electronic device (100), in particular a control device, comprising a housing (10), which has a cavity (20) and in which a circuit carrier (30) populated with electrical and/or electronic components (50) is arranged so as to form an electrical and/or electronic circuit (40), and comprising a fuse element (65), which is contact-connected to the circuit carrier (30) and serves to protect the electrical and/or electronic circuit (40) from electrostatic discharges (E),
**characterized in that**
the electrical and/or electronic circuit (40) comprises a plug contact (60), which has connection pins (61, 62) and the connection pins (62) are contact-connected to the circuit carrier (30), wherein at least one connection pin (65) is formed as the fuse element by virtue of the at least one connection pin (65) being connected to an earth line and a smallest distance (d) between the housing (10) and an electrically conductive region of the electrical and/or electronic circuit (40) is provided at a point of the at least one connection pin (65) formed as the fuse element, as a result of which a preferred discharge path is formed between the housing (10) and the earth line in the case of an electrostatic discharge (E).

2. Electronic device (100) according to Claim 1,
**characterized in that**
the discharge path is led via a spark gap (F) that bridges the smallest distance (d).

3. Electronic device (100) according to Claim 1,
**characterized in that**
the at least one connection pin (65) formed as the fuse element makes contact with the housing (10), in particular in a resilient manner.

4. Electronic device (100) according to one of the preceding claims,
**characterized in that**
the housing (10) has a formation (12.1, 12.5) projecting into the cavity (10) and the smallest distance (d) is formed with respect to the formation (12.1, 12.5).

5. Electronic device (100) according to Claim 4,
**characterized in that**
the housing (10) comprises at least two housing elements (11, 12) forming the cavity (20), wherein at least one of the housing elements (11, 12) is formed as a cast part or as a sheet metal part, wherein the formation (12.1, 12.5) in the housing (10) is provided as a dome top in the cast part or as a depression in the sheet metal part.

6. Electronic device (100) according to one of the preceding claims,
**characterized in that**
the connection pins (62) are each plugged through by way of one end thereof from a side (31) of the circuit carrier (30) and protrude from the other side (32) of the circuit carrier (30), wherein the point of the smallest distance (d) is given by the protruding end of the at least one connection pin (65) formed as a fuse element.

7. Electronic device (100) according to Claim 6,
**characterized in that**
the protruding end of the at least one connection pin (65) formed as the fuse element is formed to be longer than the protruding end of the other connection pins (62) .

8. Electronic device (100) according to one of the preceding claims,
**characterized in that**
the cavity (20) in the housing (10) is bounded by housing sides and the smallest distance (d) is given with respect to an edge region of one of the housing sides.

9. Electronic device (100) according to one of the preceding claims,
**characterized in that**
the electronic device (100) comprises a plug contact (60) leading out of the housing (10).

## Revendications

1. Appareil électronique (100), notamment un appareil de commande, pourvu d'un boîtier (10), lequel comporte une cavité (20) et dans lequel est placé un support de circuit (30) équipé de composants (50) électriques et/ou électroniques en créant un circuit électrique et/ou électronique (40) et pourvu d'un élément fusible (65) en contact avec le support de circuit (30), destiné à protéger le circuit électrique et/ou électronique (40) de décharges électrostatiques (E),
**caractérisé en ce que**
le circuit électrique et/ou électronique (40) comprend un contact de prise (60) lequel comporte des broches de connexion (61, 62) et les broches de connexion (62) sont mises en contact avec le support de circuit (30), au moins une broche de connexion (65) étant conçue sous la forme de l'élément fusible, par le fait que l'au moins une broche de connexion (65) est reliée avec une ligne de masse et qu'un écart (d) le plus petit entre le boîtier (10) et une zone conductrice d'électricité du circuit électrique et/ou électronique (40) est donné en un endroit de l'au moins une broche de connexion (65) conçue sous la forme de l'élément fusible, suite à quoi, lors d'une décharge électrostatique (E), un chemin de décharge préférentiel est créé entre le boîtier (10) et la ligne de masse.

2. Appareil électronique (100) selon la revendication 1,
**caractérisé en ce que**
le chemin de décharge est conduit par l'intermédiaire d'un éclateur (F) chevauchant le plus petit écart (d).

3. Appareil électronique (100) selon la revendication 1,
**caractérisé en ce que**
l'au moins une broche de connexion (65) conçue sous la forme de l'élément fusible est en contact avec le boîtier (10), notamment de manière résiliente.

4. Appareil électronique (100) selon l'une quelconque des revendications précédentes,
**caractérisé en ce que**
le boîtier (10) comporte un façonnage (12.1, 12.5) débordant dans la cavité (20) et le plus petit écart (d) est créé par rapport au façonnage (12.1, 12.5).

5. Appareil électronique (100) selon la revendication 4,
**caractérisé en ce que**
le boîtier (10) comporte au moins deux éléments de boîtier (11, 12) créant la cavité (20), au moins l'un des éléments de boîtier (11, 12) étant conçu sous la forme d'une pièce moulée ou d'une pièce en tôle, le façonnage (12.1, 12.5) étant prévu dans le boîtier (10) sous la forme d'un embout en dôme dans la pièce moulée ou sous la forme d'un creux dans la pièce en tôle.

6. Appareil électronique (100) selon l'une quelconque des revendications précédentes,
**caractérisé en ce que**
les broches de connexion (62) sont insérées chacune par l'une de leurs extrémités d'un côté (31) du support de circuit (30) et débordent de l'autre côté (32) du support de circuit (30), l'emplacement du plus petit écart (d) étant donné par l'extrémité débordante de l'au moins une broche de connexion (65) conçue sous la forme de l'élément fusible.

7. Appareil électronique (100) selon la revendication 6,
**caractérisé en ce que**
l'extrémité débordante de l'au moins une broche de connexion (65) conçue sous la forme de l'élément fusible est conçue en étant plus longue que les extrémités débordantes des broches de connexion (62) restantes.

8. Appareil électronique (100) selon l'une quelconque des revendications précédentes,
**caractérisé en ce que**
la cavité (20) est délimitée dans le boîtier (10) par des faces du boîtier et le plus petit écart (d) est donné par rapport à une zone de bordure de l'une des faces du boîtier.

9. Appareil électronique (100) selon l'une quelconque des revendications précédentes,
**caractérisé en ce que**
l'appareil électronique (100) comprend un contact de prise (60) tiré hors du boîtier (10).
